Europäisches Patentamt

European Patent Office

Office européen des brevets

(19)

(11) **EP 0 725 476 A1**

(12) **EUROPEAN PATENT APPLICATION**
published in accordance with Art. 158(3) EPC

(43) Date of publication:
07.08.1996 Bulletin 1996/32

(51) Int. Cl.$^6$: **H02N 2/00**

(21) Application number: 95928021.5

(86) International application number:
PCT/JP95/01609

(22) Date of filing: 11.08.1995

(87) International publication number:
WO 96/06482 (29.02.1996 Gazette 1996/10)

(84) Designated Contracting States:
DE FR GB IT NL

(30) Priority: 19.08.1994 JP 195537/94
27.01.1995 JP 11807/95

(71) Applicant: MITSUI PETROCHEMICAL
INDUSTRIES, LTD.
Tokyo 100 (JP)

(72) Inventors:
• KANAYAMA, Kouichi
Mitsui Petrochemical Industries
Chiba 299-02 (JP)

• SAIGOH, Hiroaki
Mitsui Petrochemical Industries
Chiba 299-02 (JP)
• KAWASAKI, Mayumi
Mitsui Petrochemical Industries
Chiba 299-02 (JP)
• MARUKO, Nobuhiro
Mitsui Petrochemical Industries
Chiba 299-02 (JP)

(74) Representative: Senior, Alan Murray et al
J.A. KEMP & CO.,
14 South Square,
Gray's Inn
London WC1R 5LX (GB)

(54) **PIEZOELECTRIC VIBRATOR FOR ULTRASONIC WAVE MOTOR, PRODUCTION METHOD THEREOF, METHOD OF MOUNTING PIEZOELECTRIC VIBRATOR AND ULTRASONIC WAVE MOTOR**

(57)    The piezoelectric vibrator for ultrasonic motors of the present invention is one capable of causing a piezoelectric vibrator component to generate a longitudinal vibration/bending vibration to thereby drive a moving element, said piezoelectric vibrator comprises a piezoelectric vibrator component and, bonded thereto through an elastic member, either a mounting member having means for bonding with a fixture or a fixture. This piezoelectric vibrator for ultrasonic motors is free from lowering the resonance characteristics of the piezoelectric vibrator component and enables operating the ultrasonic motor in high efficiency. Further, the assembly of the piezoelectric vibrator into the ultrasonic motor can be effected more easily and more securely than in the prior art and the stability and reliability thereof can markedly be improved at the time of motor operation.

The ultrasonic motor of the present invention is an ultrasonic motor of the standing-wave type comprising a piezoelectric vibrator provided with a wear resisting member at its face opposite to a driving surface in the vicinity of an end thereof in the driving direction and bonded with a magnet for pressurizing the piezoelectric vibrator against the driving surface composed of a magnetic material by means of a bonding material, said magnet being disposed apart from the driving surface.

This ultrasonic motor attains not only simplification of the pressurization mechanism and miniaturization of the motor and further ensures high driving efficiency.

FIG. 1

EP 0 725 476 A1

## Description

### TECHNICAL FIELD

The present invention relates to a piezoelectric vibrator for ultrasonic motors provided with a mounting member for enabling bonding with a fixture, a piezoelectric vibrator for ultrasonic motors provided with a fixture, a method of mounting a piezoelectric vibrator, a piezoelectric vibrator for ultrasonic motors provided with a bonding member for enabling bonding with a fixture, a process for producing the same and an ultrasonic motor of the standing-wave type in which magnetic force is employed as means for pressurizing a piezoelectric vibrator.

### BACKGROUND ART

In recent years, the ultrasonic motor is drawing attention as a motor which does not require wire winding so as to be beneficial for, for example, miniaturizing equipment. The ultrasonic motors are classified into those of the standing-wave type and the traveling-wave type. The ultrasonic motor of the traveling-wave type has become popular as a rotary motor. On the other hand, the ultrasonic motor of the standing-wave type promises use in linear operation.

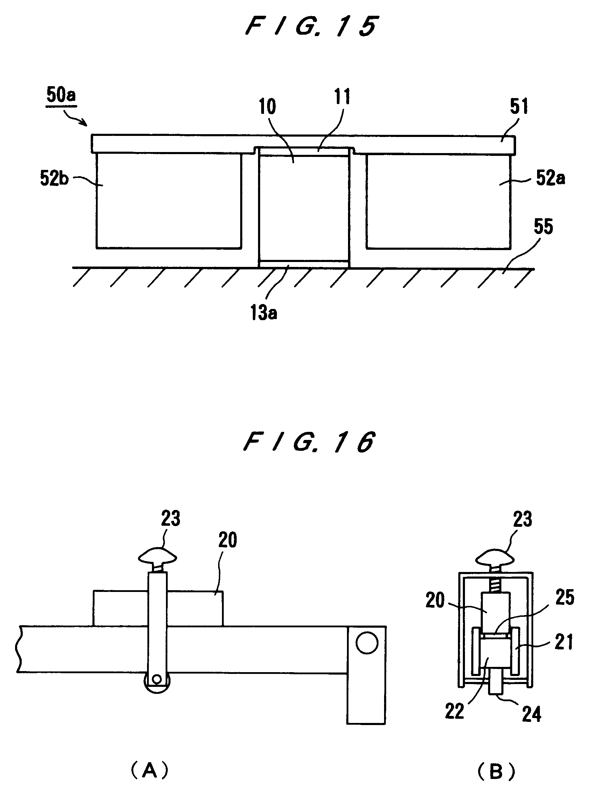

In the above ultrasonic motor, it is inevitable to fix a piezoelectric vibrator and apply pressure thereto. For example, in the piezoelectric vibrator composing the ultrasonic motor suitable for linear operation, the piezoelectric vibrator component 20 disposed on the rail 22 has been assembled thereinto by supporting the same with support plates 21 and by applying pressure with a screw 23, for example, as shown in Fig. 16. In Fig. 16, numeral 24 denotes a bearing and numeral 25 a friction material.

The conventional piezoelectric vibrator has no means for mounting as mentioned above, so that, when it is assembled into the ultrasonic motor, it has been inevitable to support the piezoelectric vibrator with, for example, support plates in a manner such that the piezoelectric vibrator is interposed between the support plates without detriment to the mechanical vibration of the piezoelectric vibrator while applying pressure to the piezoelectric vibrator with, for example, a screw as mentioned above. However, with the use of this method, it has been difficult to maintain stable operation for a prolonged period of time. Further, the method of directly fixing the piezoelectric vibrator to the fixture with a screw or an adhesive has encountered the problems that not only is the natural resonance frequency of the vibrator in which the point of the exhibition of motor operation lies changed by fixing the piezoelectric vibrator with detriment to the ideal bond between vibration modes but also the mechanical vibration energy is scattered through the above fixture toward the equipment side to thereby cause an efficiency lowering.

The inventors have made extensive and intensive studies. As a result, it has been found that the above problems can be resolved by bonding the piezoelectric vibrator through an elastic member with a mounting member or a fixture.

The operational characteristics of the motor may be largely varied depending on the method of fixing the piezoelectric vibrator and the position where the piezoelectric vibrator is fixed. In particular, in the motor of the standing-wave type (multimode type), the position in which the piezoelectric vibrator is fixed exerts respective independent effects on two natural vibration characteristics. In the motor of the standing-wave type, matching of the two natural vibrations is important, so that it is believed that the fixing of the piezoelectric vibrator is effective at a node part of vibration where the natural vibration of the piezoelectric vibrator is not inhibited.

The use of a fixture provides a simple method of fixing the piezoelectric vibrator at the node part. This requires a certain extent of adhesive face area, so that it is difficult to conduct an ideal point fixing. Further, the clamp fixing of the node part with the use of, for example, a bolt would cause the stable fixing of the piezoelectric vibrator to be difficult and also would render the mechanism thereof complex.

Therefore, it would be contemplated to machine the piezoelectric vibrator so as to provide the node part thereof with fixing means. The piezoelectric ceramic vibrator can be machined either prior to or after the sintering thereof. The machining prior to the sintering has been difficult because the powder molding of ceramic vibrator is mechanically brittle. On the other hand, the machining after the sintering has required a special technique such as ultrasonic machining.

The inventors have made extensive and intensive studies. As a result, it has been found that the piezoelectric vibrator having fixing means at the node part of a side face thereof can be produced by a process comprising forming a recessed part at a side face of a green sheet laminate on a site which becomes a node part at the time of formation of a piezoelectric vibrator, thereafter firing and fitting a bonding member in the above recessed part.

In the ultrasonic motor, generally, the piezoelectric vibrator is pressurized onto the driving surface to thereby fix the same by mechanical pressurization with the use of, for example, a screw or a spring. This method not only increases the number of needed parts but also renders the pressurization mechanism complex, so that the freedom of motor construction is gravely restricted. Further, it has occurred that the means for pressurization such as a spring comes into contact with, for example, a rotor to thereby lower the motor efficiency.

Thus, various methods have been studied for simplifying the pressurization mechanism. For example, Japanese Patent Laid-open Publication No. SHO 59(1984)-185179 proposed the method of using a magnet as means for pressurizing the vibrator to the mover (rotor) to thereby contact them each other in the ultrasonic motor. The ultrasonic motor described therein is a motor of the traveling-elastic-wave type, which requires a large contact area throughout the interface between the vibrator and the mover for obtaining a driving force. The application of at least a certain level of pressure per area is required for producing the driving force. However, the pressing force is dispersed when the contact area is large, so that the application of a high pressure is required for producing the driving force. As shown in the Examples of the above laid-open publication, the magnetic force is gravely lowered when an inclusion (friction body) exists between the magnet and the magnetic body (vibrator), so that any pressurization using the magnetic force requires a large strong magnet capable of covering a wide range of contact area. Therefore, the motor of the traveling-elastic-wave type encounters a limitation in the use of a magnet as means for miniaturizing the motor and means for causing the vibrator and the mover to contact each other under pressure.

Moreover, Japanese Patent Laid-open Publication No. Hei 4(1992)-88890 proposed rotary and linear motors which rendered it unnecessary to provide pressurization means between the elastic mover and the moving element by the employment of an ultrasonic motor of the traveling-wave type in combination with a permanent magnet. However, the motors disclosed therein not only have the same drawbacks as above but also lack configuration freedom because of the use of the vibrator in the form of a race track. Further, in the case of the linear motor, it encounters the problem that a material simultaneously having both magnetism and elasticity as moving element properties is needed.

The inventors have conducted extensive and intensive investigations. As a result, it has been found that an ultrasonic motor of the standing-wave in which the magnet for pressurizing the piezoelectric vibrator onto the driving surface composed of a magnetic material is bonded thereto by means of a bonding member and in which the magnet is disposed apart from the driving surface can resolve the above problems.

DISCLOSURE OF THE INVENTION

The first piezoelectric vibrator for ultrasonic motors according to the present invention capable of causing a piezoelectric vibrator component to generate a longitudinal vibration/bending vibration to thereby drive a moving element, said piezoelectric vibrator comprises a piezoelectric vibrator component and a mounting member having means for bonding with a fixture, said piezoelectric vibrator component and mounting member being bonded thereto (combined therewith) through an electric member.

In this piezoelectric vibrator for ultrasonic motors, the natural vibration of the piezoelectric vibrator component is elastically separated from the mounting member by means of the elastic member, so that the resonance characteristics of the piezoelectric vibrator component are not deteriorated to thereby enable operating the ultrasonic motor in high efficiency. Further, the assembly of the piezoelectric vibrator into the ultrasonic motor can be accomplished more easily and more securely than in the prior art to thereby enable strikingly enhancing the stability and reliability of the motor at the time of the operation of the motor.

In the present invention, the above piezoelectric vibrator component may have a face opposite to the moving element, provided with a wear resisting member. Further, in the present invention, the above mounting member may be provided with an electric input terminal.

The second piezoelectric vibrator for ultrasonic motors according to the present invention is capable of causing a piezoelectric vibrator component to generate a longitudinal vibration/bending vibration to thereby drive a moving element, said piezoelectric vibrator comprises a piezoelectric vibrator component and a fixture, said piezoelectric vibrator component and fixture being bonded through an elastic member.

In this piezoelectric vibrator for ultrasonic motors, the natural vibration of the piezoelectric vibrator component is elastically separated from the fixture by means of the elastic member, so that the resonance characteristics of the piezoelectric vibrator component are not deteriorated to thereby enable operating the ultrasonic motor in high efficiency. Further, the assembly of the piezoelectric vibrator into the ultrasonic motor can be accomplished more easily and more securely than in the prior art to thereby enable strikingly enhancing the stability and reliability of the motor at the time of the operation of the motor.

The method of mounting a piezoelectric vibrator according to the present invention comprises bonding a piezoelectric vibrator component through an elastic member to a fixture, the above piezoelectric vibrator component being capable of generating a longitudinal vibration/bending vibration to thereby drive a moving element.

In this method of mounting a piezoelectric vibrator, the natural vibration of the piezoelectric vibrator component is elastically separated from the fixture by means of the elastic member, so that the resonance characteristics of the piezoelectric vibrator component are not deteriorated to thereby enable operating the ultrasonic motor in high efficiency. Further, the stability and reliability of the motor at the time of the operation of the motor can strikingly be enhanced.

The term "fixture" used in the present invention means an instrument, a part, a device or any other article (material body) having the capability of fixing or holding the piezoelectric vibrator. The fixture for use in the present invention may have other functions as long as it has the capability of fixing or holding the piezoelectric vibrator.

The third piezoelectric vibrator for ultrasonic motors according to the present invention comprises a cofiring laminated piezoelectric vibrator for ultrasonic motors having respective protrudent bar-shaped bonding members in opposite side surface thereof for enabling bonding with fixtures, each of the above bonding members being partly fitted in a recessed part formed at a node part of the corresponding side face of the laminated piezoelectric vibrator.

This piezoelectric vibrator for ultrasonic motors has bonding members for enabling bonding with fixtures, so that the assembly thereof into the ultrasonic motor is easy. Further, each of the bonding members is disposed at the node part of vibration, so that the natural vibration of the piezoelectric vibrator is not inhibited.

In the present invention, it is preferred that the above laminated piezoelectric vibrator be a piezoelectric vibrator utilizing a longitudinal vibration mode/bending vibration mode.

The process for producing a piezoelectric vibrator for ultrasonic motors according to the present invention comprises integrally laminating green sheets each composed mainly of a ceramic material having piezoelectric effect to thereby obtain a green sheet laminate; forming respective recessed parts at opposite side faces of the green sheet laminate on sites which become node parts at the time of formation of a piezoelectric vibrator and thereafter firing the green sheet laminate to thereby obtain a ceramic laminate; and fitting one end of each bar-shaped bonding member for enabling bonding with a fixture in the corresponding recessed part of the ceramic laminate, thereby obtaining a laminated piezoelectric vibrator having the bonding members protruding from the respective side faces.

In this process for producing a piezoelectric vibrator for ultrasonic motors, drilling is easy and a piezoelectric vibrator for ultrasonic motors having a bonding member for bonding with a fixture can be obtained without the need of employing any special technique, as different from the process for producing a piezoelectric vibrator from a powder molding.

The first ultrasonic motor of the present invention is an ultrasonic motor of the standing-wave type comprising a piezoelectric vibrator capable of exciting two modes of natural vibrations different from each other when a driving voltage is applied thereto, the above ultrasonic motor utilizing as a driving force an elliptic motion synthesized from the two modes of natural vibrations and a frictional force occurring between the piezoelectric vibrator and a driving surface, wherein the above piezoelectric vibrator is provided with a wear resisting member at its face opposite to the driving surface in the vicinity of an end thereof when facing in the driving direction and is bonded (combined to form an integral body) with a magnet for pressurizing the piezoelectric vibrator against the driving surface composed of a magnetic material by means of a bonding material, the above magnet being disposed apart from the driving surface.

This ultrasonic motor enables simplification of the pressurization mechanism and also miniaturization of the motor. Further, it ensures high driving efficiency.

In the present invention, the above bonding material may be composed of a magnetic material, so that the magnet is bonded with the bonding material by magnetic force. Further, it is preferred that the above piezoelectric vibrator be a laminated piezoelectric vibrator utilizing a longitudinal vibration mode/bending vibration mode. Still further, it is preferred that the above piezoelectric vibrator and bonding material be bonded with each other in nonadhering (nonfixed) relationship. Moreover, it is preferred that the above piezoelectric vibrator and bonding material be bonded (combined to form an integral body) with each other through an elastic member.

BRIEF DESCRIPTION OF THE DRAWING

Fig. 1 is a schematic perspective view showing the first example of the first piezoelectric vibrator for ultrasonic motors according to the present invention.

Fig. 2 (A) is a schematic side view showing one form of laminated piezoelectric vibrator; Fig. 2 (B) an explanatory view showing the longitudinal division of the above piezoelectric vibrator into elements; and Fig. 2 (C) a schematic front view of the above piezoelectric vibrator.

Fig. 3 is an explanatory view showing one mode of assembling the first embodiment of the piezoelectric vibrator for ultrasonic motors.

Fig. 4 is a schematic perspective view showing the second embodiment of the first piezoelectric vibrator for ultrasonic motors according to the present invention.

Fig. 5 (A) is a schematic side view showing one form of piezoelectric vibrator of a single plate; Fig. 5 (B) an explanatory view showing the longitudinal division of the above piezoelectric vibrator into elements; and Fig. 5 (C) a schematic front view of the above piezoelectric vibrator.

Fig. 6 is a schematic perspective view showing the third embodiment of the first piezoelectric vibrator for ultrasonic motors according to the present invention.

Fig. 7 (A) is a schematic perspective view showing the fourth embodiment of the first piezoelectric vibrator for ultrasonic motors according to the present invention and Fig. 7 (B) a longitudinal sectional view of Fig. 7 (A).

Fig. 8 is a diagram showing the relationship between the pressing force and the moving speed when a piezoelectric vibrator for ultrasonic motors having an elastic member of 0.1 mm in thickness is operated.

Fig. 9 is a diagram showing the relationship between the pressing force and the moving speed when a piezoelectric vibrator for ultrasonic motors having an elastic member of 0.6 mm in thickness is operated.

Fig. 10 (A) is a partially cut-away schematic side view showing one form of ultrasonic motor in which the second piezoelectric vibrator for ultrasonic motors according to the present invention is applied, and Fig.

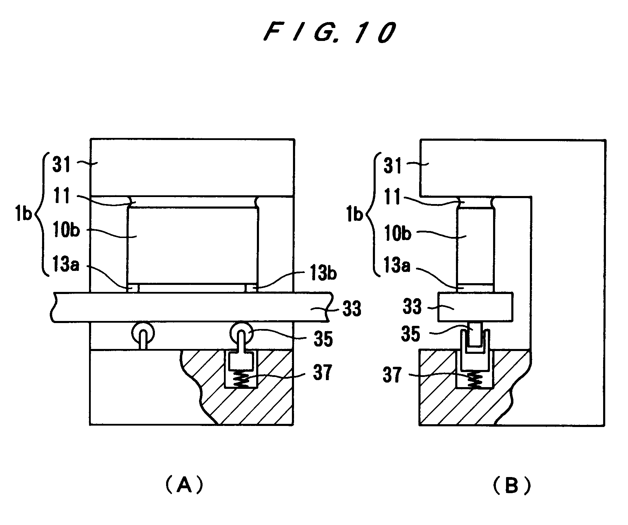

10 (B) a partially cut-away schematic front view of Fig. 10 (A).

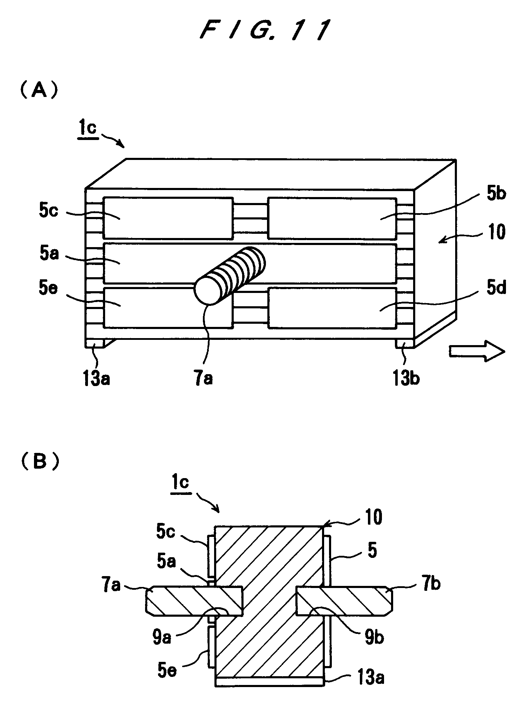

Fig. 11 (A) is a schematic perspective view showing one example of the third piezoelectric vibrator for ultrasonic motors according to the present invention, and Fig. 11 (B) a schematic sectional view of the above piezoelectric vibrator.

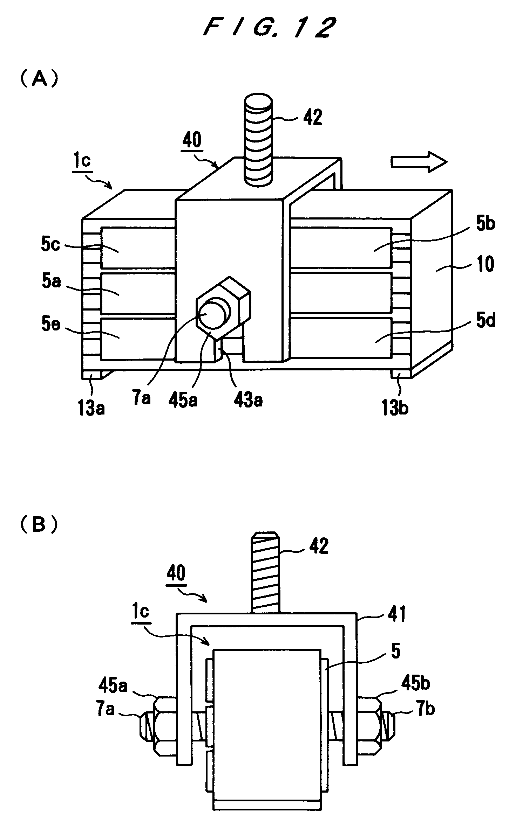

Fig. 12 (A) is a schematic perspective view showing an arrangement in which the piezoelectric vibrator for ultrasonic motors of Fig. 11 has been fixed to a fixture, and Fig. 12 (B) a schematic front view of the above arrangement.

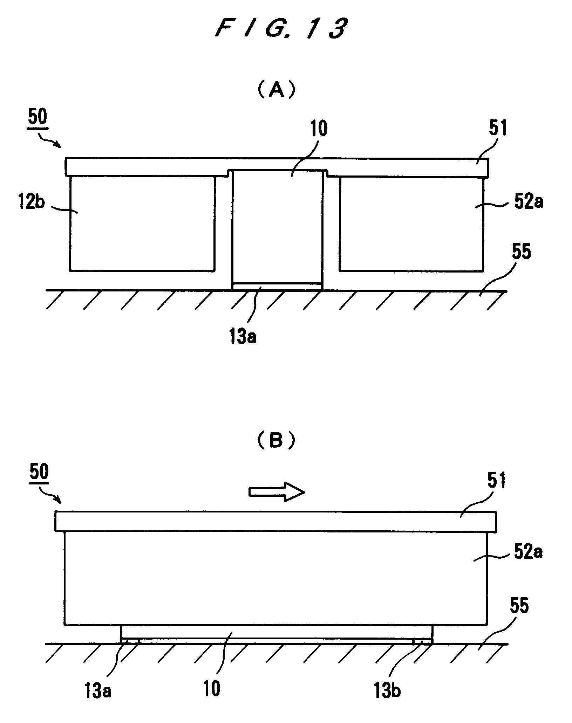

Fig. 13 (A) is a schematic front view showing one embodiment of the first ultrasonic motor of the present invention, and Fig. 13 (B) a schematic side view of the ultrasonic motor shown in Fig. 13 (A).

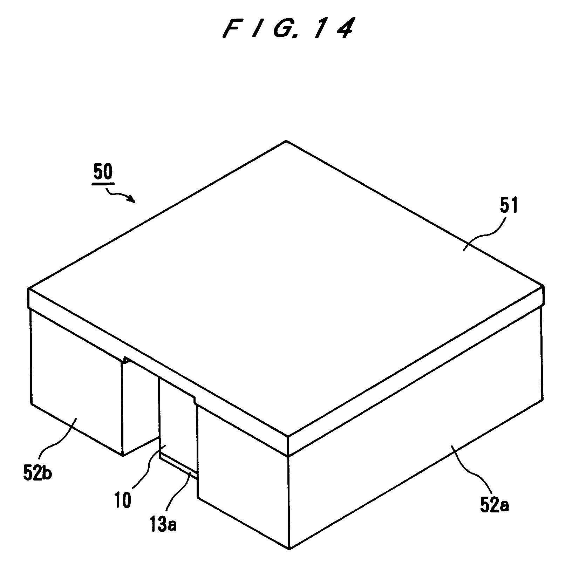

Fig. 14 is a schematic perspective view of the ultrasonic motor shown in Fig. 13.

Fig. 15 is a schematic front view showing one embodiment of the second ultrasonic motor of the present invention.

Fig. 16 (A) is a schematic side view showing the method of assembling the conventional piezoelectric vibrator for ultrasonic motors, and Fig. 16 (B) is a schematic front view of Fig. 16 (A).

## BEST MODE FOR CARRYING OUT THE INVENTION

Referring to drawings, the first and second piezoelectric vibrators for ultrasonic motors and the method of mounting the piezoelectric vibrator according to the present invention will be described in detail below.

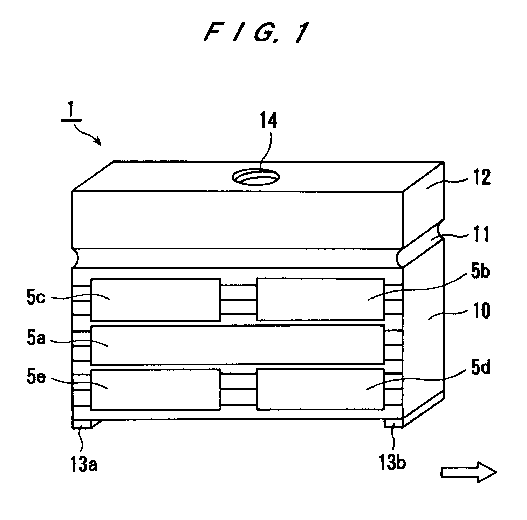

Referring specifically to Fig. 1, the first piezoelectric vibrator 1 for ultrasonic motors according to the present invention comprises a piezoelectric vibrator component 10 and a mounting member 12 having bonding means 14, and the piezoelectric vibrator component 10 and the mounting member 12 are bonded together through an elastic member 11. The piezoelectric vibrator component 10 has a sliding face provided with wear resisting members 13a, 13b.

The piezoelectric vibrator component 10 is a piezoelectric vibrator utilizing a longitudinal vibration/bending vibration (vibration of a combination of longitudinal vibration mode and bending vibration mode) as described later. When a driving voltage is applied thereto, elliptic motions occur at front and rear ends in the driving direction, of the face (sliding face) of the piezoelectric vibrator component 10 opposite to, for example, the moving element and the driving surface, so that a driving force is produced in a fixed direction. In the piezoelectric vibrator component 10 shown in Fig. 1, the driving force is produced in the arrowed or opposite direction.

Linear wear resisting members 13a, 13b arranged substantially perpendicularly to the driving direction are provided at front and rear ends in the driving direction, of the sliding face of the piezoelectric vibrator component 10. Although linear wear resisting members 13a, 13b are provided at ends of the sliding face of the piezoelectric vibrator component 10 in this example, either planar wear resisting members may be provided in the vicinity of front and rear ends in the driving direction, of the sliding face or a planar wear resisting member may be provided throughout the sliding face in the present invention.

Although the thickness of the wear resisting member 13a, 13b is not particularly limited, it generally ranges from 10 to 1000 $\mu$m and preferably from 100 to 600 $\mu$m.

The wear resisting member 13a, 13b can be composed of any of various materials which include, for example, glasses such as soda, lead, borosilicate (e.g., Pyrex (trade mark)), crown, flint, dense flint and quartz glasses; ceramics such as alumina, zirconia, silicon carbide, silicon nitride, tungsten carbide and titanium carbide; and glass-coated ceramics. Of these, quartz glass is especially preferred.

It is preferred that the surface roughness of the wear resisting member 13a, 13b be low. Specifically, it is preferred that the center line average roughness (Ra) thereof range from 5 to 50 Å as measured by a surface roughness meter according to the tracer method.

The above wear resisting members 13a, 13b can be disposed on the sliding face of the piezoelectric vibrator component 10 with the use of, for example, an adhesive.

The mounting member 12 is disposed on the top face of the piezoelectric vibrator component 10 with the elastic member 11 interposed therebetween.

A tapped hole as bonding means 14 for enabling bonding with a fixture for fixing the piezoelectric vibrator 1 for ultrasonic motors is formed in the top face of the mounting member 12. In this embodiment, the piezoelectric vibrator 1 for ultrasonic motors is fixed to the fixture by means of a bolt.

Although the mounting member 12 has the shape of substantially a rectangular parallelopiped in this example, the shape of the mounting member 12 for use in the present invention is not limited thereto and various shapes can be employed as long as the objects of the present invention can be attained. Further, although the bonding means is a tapped hole (internal thread) formed in the top face of the mounting member 12 in this embodiment, the bonding means to be provided at the top face of the mounting member 12 in present invention is not limited thereto and any of the conventional bonding means such as a pin hole, a screw (external thread) and a cylindrical protrusion can be employed. It is preferred that the above bonding means be formed around the center of the top face of the mounting member 12. When the bonding means is formed around the center of the top face of the mounting member 12, the lowering of the driving efficiency of the piezoelectric vibrator is minimized.

The mounting member 12 can be composed of any of various materials which include, for example, metals such as aluminum alloys, brass and stainless steel and other iron-based alloys; ceramics such as alumina, zirconia, silicon carbide, silicon nitride and magnesia; and synthetic resins such as polyamides, polyimides, phenol resins, polybutylene terephthalate and polyphenylene sulfide.

Substantially all the surface of the top face of the piezoelectric vibrator component 10 and substantially all the surface of the bottom face of the mounting member 12 are bonded together through the elastic member 11 so as to form an integral body of the piezoelectric vibrator component 10 and the mounting member 12.

Examples of elastic materials for composing the elastic member 11 include silicone, butadiene, styrene/butadiene, isoprene, ethylene/propylene, butyl, acrylonitrile/butadiene, carboxynitrile, acrylic, hydrogenated nitrile and urethane rubbers.

The thickness of the elastic member 11 generally ranges from about 0.1 to 2.5 mm and preferably from about 0.1 to 1 mm.

The elastic member 11 can be bonded with the piezoelectric vibrator component 10 and also the elastic member 11 can be bonded with the mounting member 12, with the use of, for example, an adhesive. Alternatively, the above bondings can be effected by providing the elastic member 11 with bonding capacity.

The piezoelectric vibrator component 10 is a piezoelectric vibrator utilizing a longitudinal vibration/bending vibration. In this embodiment, the piezoelectric vibrator is a laminated piezoelectric vibrator.

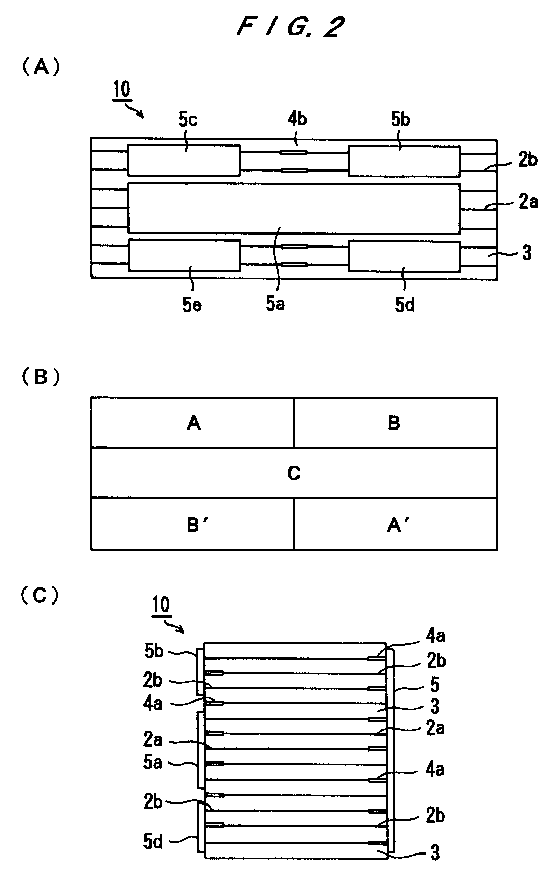

The laminated piezoelectric vibrator is divided into five driving elements consisting of elements A and B arranged in the upper part, element C arranged in the middle part and elements A' and B' arranged in the lower part as shown in Fig. 2 (B). With respect to the driving elements, the elements A, A', B and B' are for exciting second bending vibration while the element C is for exciting first longitudinal vibration.

Referring to Fig. 2 (A) and (C), each of the elements A, A', B, B' and C is a laminate of a plurality of ceramic sheets 3 composed mainly of a material having piezoelectric effect, in which an inside electrode 2a or 2b is interposed between neighboring ceramic sheets 3. Outside electrodes 5a, 5b, 5c, 5d and 5e are formed on one of mutually opposite side faces of the piezoelectric vibrator component 10 and outside electrode 5 is formed on the other side face.

Each of the elements A, A', B and B' is formed by laminating ceramic sheets 3 with each inside electrode 2b interposed between neighboring ceramic sheets 3. The element A is separated from the element B and the element A' from the element B' at substantially the center of the longitudinal length of the ceramic sheets 3 by means of an insulating part 4b.

In the element A, every other inside electrode layer 2b has its one end in the short side direction connected to the outside electrode 5c. Each inside electrode 2b not connected to the outside electrode 5c has its one end in the short side direction connected to the outside electrode 5. In the element A', every other inside electrode layer 2b has its one end, when facing in the short side direction connected to the outside electrode 5d. Each inside electrode 2b not connected to the outside electrode 5d has its one end in the short side direction connected to the outside electrode 5.

In the element B, every other inside electrode layer 2b has its one end in the short side direction connected to the outside electrode 5b. Each inside electrode 2b not connected to the outside electrode 5b has its one end in the short side direction connected to the outside electrode 5. In the element B', every other inside electrode layer 2b has its one end in the short side direction connected to the outside electrode 5e. Each inside electrode 2b not connected to the outside electrode 5e has its one end in the short side direction connected to the outside electrode 5.

The element C consists of a laminate of ceramic sheets 3 with each inside electrode 2a interposed between neighboring ceramic sheets 3, in which no insulating part is provided as different from the elements A and B. In the element C, every other inside electrode layer 2a has its one end in the short side direction connected to the outside electrode 5a. Each inside electrode 2a not connected to the outside electrode 5a has its one end in the short side direction connected to the outside electrode 5.

Referring to Fig. 2 (C), a plurality of insulating parts 4a are provided in respective inside electrodes of the elements A, A', B, B' and C so as to position alternately right and left in the lamination direction. In the present invention, it is not always necessary to arrange the insulating parts alternately right and left, and it is satisfactory if the insulating part positions are shifted from each other between two ceramic sheets neighboring in the lamination direction but identical with each other between two ceramic sheets with another ceramic sheet interposed therebetween. The insulating part 4a is generally a gap. The insulating part 4a is not shown in Fig. 2 (A).

In each of the elements A, A', B and B', the lamination is generally 2 to 30 and preferably 3 to 20 ceramic sheets 3. In the element C, also, the lamination is generally 2 to 30 and preferably 3 to 20 ceramic sheets 3.

The ceramic sheet 3 is composed of a material having piezoelectric effect (piezoelectric material). Examples of the suitable materials include ceramics having piezoelectric effect, for example, PZT system ceramics and $PbTiO_3$ system ceramics such as $PbTiO_3$. Examples of the suitable PZT system ceramics include PZT and $Pb(Ni_{1/3}Nb_{2/3})O_3$-$Pb(Zn_{1/3}Nb_{2/3})O_3$-$PbTiO_3$-$PbZrO_3$ system ceramics.

The above piezoelectric vibrator component 10 can be produced by, for example, the following process.

First, for example, a solvent, a binder and a plasticizer are added to calcined ceramic powder as a major component and mixed to thereby prepare a slurry.

When water is used as the solvent, hydroxyethylcellulose, methylcellulose, polyvinyl alcohol, a wax lubricant, carboxymethylcellulose or the like is used as the binder, and glycerol, a polyalkyl glycol, a sorbitan acid ester, triethylene glycol, petrol, a polyol or the like is used as the plasticizer. On the other hand, when an organic solvent such as ethyl alcohol, methyl ethyl ketone, benzene or toluene is used as the solvent, polymethyl methacrylate, polyvinyl alcohol, polyvinylbutyral, cellulose acetate or the like is used as the binder, and dibutyl phthalate, polyethylene glycol, glycerol or the like is used as the plasticizer.

The obtained slurry is formed into a thin plate according to the doctor blade technique, the extrusion molding technique or the like and cut into a predetermined shape to thereby obtain a green sheet. This green sheet is dried and cut into a predetermined shape to thereby obtain a ceramic sheet precursor. Although the thickness of this ceramic sheet precursor is not particularly limited, it is preferred to range from 0.02 to 2 mm, especially, from 0.05 to 0.5 mm.

A preferred green sheet manufacturing method comprises conducting extrusion with the use of water as the solvent to attain the sheeting. In this method, not only is it easy to reduce the amount of added binder and/or plasticizer but also the mutual adherence of ceramic sheet precursors is reduced in the dry state. Thus, when ceramic sheet precursors are laminated and fired, the adhesion of neighboring upper and lower ceramic sheet precursors can be prevented at the insulating part 4a, 4b, so that it becomes easy to securely form a gap (insulating part) at the above part. Nevertheless, green sheets adapted to securely form the insulating part 4a, 4b can be obtained by the extrusion technique in which an organic solvent is used or the doctor blade technique in which an organic solvent or water is used if the type and amount of added binder and plasticizer are appropriately selected.

The types and amounts of added binder and plasticizer and the conditions for drying the green sheet are selected so as for the tensile shear bond strength of a complex obtained by pressurizing a combination of ceramic sheet precursors under 20 to 200 kg/cm$^2$ at 50 to 150°C to be not greater than 10%, preferably, not greater than 5% of the tensile strength of the ceramic sheet precursor per se.

In the green sheet manufacturing according to the extrusion technique with the use of water as the solvent, the binder is generally added in an amount of 1 to 10 parts by weight and preferably 2 to 5 parts by weight per 100 parts by weight of calcined powder. Also, the plasticizer is generally added in an amount of 1 to 10 parts by weight and preferably 2 to 5 parts by weight per 100 parts by weight of calcined powder.

A filmy inside electrode 2a, 2b can be formed by, for example, coating a surface of the ceramic sheet precursor with a metal paste. Examples of metals suitable for formation of the inside electrode 2a, 2b include platinum, palladium, silver-palladium alloy and silver or the like.

It is desired that a metal paste which can be baked at the firing temperature of the ceramic sheet precursor be selected as the metal paste for forming the inside electrode 2a, 2b because the ceramic sheet precursor is fired in the form of a laminate. For example, powdery zirconia, powdery glass and powder of the above piezoelectric material may be mixed with the metal paste in order to improve the adhesive strength between the ceramic sheet 3 and the inside electrode 2a, 2b after the firing.

In the application of the metal paste to the surface of the ceramic sheet precursor, part noncoated with the metal paste is provided at a peripheral edge of a ceramic sheet precursor to thereby form part intended for use as the insulating part 4a positioned at an end of the inside electrode 2b. Further, part noncoated with the metal paste is provided at the longitudinal center of the ceramic sheet precursor to thereby form part intended for use as insulating part 4b positioned between inside electrodes 2b, 2b. Still further, part noncoated with the metal paste is provided at a peripheral edge of another ceramic sheet precursor to thereby form part intended for use as the insulating part 4a positioned at an end of the inside electrode 2a. The shape and position of the insulating part 4a are not particularly limited, and it may be formed at one corner of the ceramic sheet precursor.

Although the thickness of the above inside electrode 2a, 2b is not particularly limited, it is preferred to range from 0.5 to 20 μm, especially, from 1 to 10 μm after the firing. The application of the metal paste can be conducted by, for example, the screen printing or the roller printing technique.

A plurality of the above ceramic sheet precursors provided with respective inside electrodes 2b are laminated together in a manner such that the insulating parts 4a position alternately right and left when facing in the lamination direction to thereby produce each of laminate A-B destined for elements A and B and laminate A'-B' destined for elements A' and B'. On the other hand, a plurality of the above ceramic sheet precursors provided with respective inside electrodes 2a are laminated together in a manner such that the insulating parts 4a position alternately right and left when facing in the lamination direction to thereby produce laminate C destined for element C. The resultant laminate A-B, laminate C and laminate A'-B' are piled one upon another in this order to thereby obtain a laminate of ceramic sheet precursors.

This laminate is subjected to contact bonding by means of a hot press, degreasing and firing at a predetermined temperature and baking of the inside electrodes 2a, 2b to thereby effect bonding between the ceramic sheets 3 and the respective inside electrodes 2a, 2b. The above laminate may be cut into a predetermined size prior to the degreasing. Alternatively, the cutting may be conducted after the firing. In the above laminate firing, neighboring upper and lower ceramic sheets 3 do not adhere to each other, so that the insulating parts 4a, 4b can be securely formed.

Referring to Fig. 2 (A) and (C), at one side face of the piezoelectric vibrator component 10, every other inside electrode layer 2a of the element C is connected to the outside electrode 5a; every other inside electrode layer 2b of the element A is connected to the outside electrode 5c; every other inside electrode layer 2b of the element A' is connected to the outside electrode 5d; every other inside electrode layer 2b of the element B is connected to the outside electrode 5b; and every other inside electrode layer 2b of the element B' is connected to the outside electrode 5e. On the opposite side face of the piezoelectric vibrator component 10, every other inside electrode layer 2a, 2b is connected to the outside electrode 5. The outside electrodes 5a, 5b, 5c, 5d and 5e are insulated from each other.

Each of these outside electrodes 5, 5a, 5b, 5c, 5d and 5e can easily be formed by applying an electrode material onto a side face in the longitudinal direction of the piezoelectric vibrator component 10 and baking the same.

Electrode materials for use in the outside electrodes 5, 5a, 5b, 5c, 5d and 5e are not particularly limited, and, for example, silver or a solder can suitably be employed.

When a voltage is impressed onto the outside electrodes 5, 5a, 5b, 5c, 5d and 5e, an electric field applies in the direction of the lamination of the piezoelectric vibrator component 10. Upon application of an electric field, not only the elements A and B but also the elements A' and B' conduct stretching and shrinkage in directions opposite to each other to thereby excite second bending vibration while the element C independently conducts stretching and shrinkage to thereby excite primary longitudinal vibration. In this connection, the elements A and A' conduct stretching and shrinkage in mutually identical directions.

Specifically, the above laminated piezoelectric vibrator component 10 is driven by, for example, the following method.

In the piezoelectric vibrator component 10, not only the elements A and B but also the elements A' and B' are polarized (poling) in respective directions opposite to each other and in which the elements A, A' and C are polarized in respective directions identical to each other. In this state a driving voltage is applied at a frequency of $\sin \omega t$ ($\omega$ is an angular frequency) to the elements A, A', B and B' and is applied at a frequency of $\cos \omega t$ ($\omega$ is an angular frequency) to the element C. Thus, the elements A, A', B and B' excite bending vibration and the element C excites stretching vibration, so that the piezoelectric vibrator component 10 conducts elliptic motion at its ends as viewed in the driving direction to thereby generate a driving force in a given direction. This driving force is transmitted to the part of contact between the sliding face of the piezoelectric vibrator component 10 and the moving element or the like or the part of contact between the wear resisting members 13a, 13b and the moving element or the like, so that the piezoelectric vibrator component 10 is driven as an ultrasonic motor by the frictional force produced at the contact part.

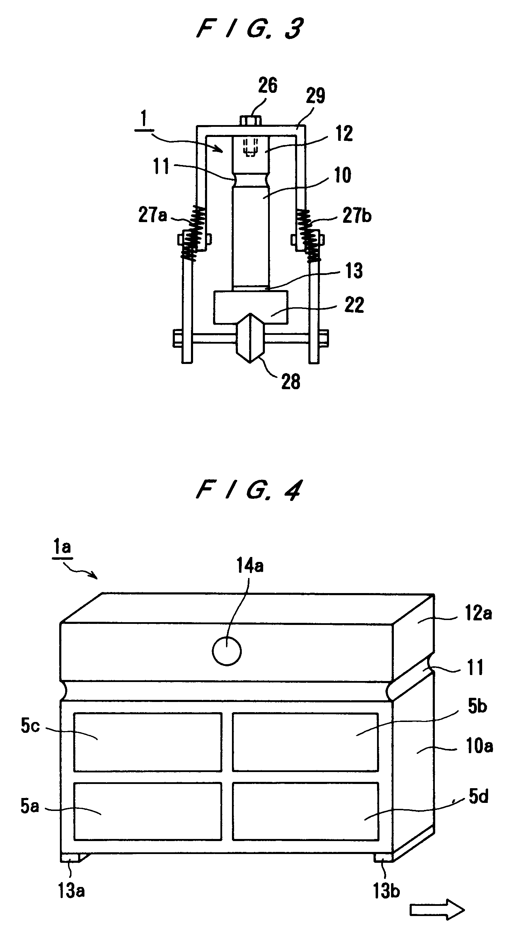

The resultant piezoelectric vibrator for ultrasonic motors according to the present invention is assembled, for example, as shown in Fig. 3. Referring to Fig. 3, the piezoelectric vibrator 1 for ultrasonic motors is mounted in the state of being fixed to a fixture 29 by means of a bolt 26 on a rail (moving element) 22 and induces downward pressurization by means of springs 27a, 27b. In Fig. 3, numeral 28 denotes a bearing.

In the piezoelectric vibrator for ultrasonic motors according to the present invention, the piezoelectric vibrator component is bonded through the elastic member to the mounting member having bonding means, so that the resonance characteristics of the piezoelectric vibrator component is not deteriorated to thereby enable highly efficient motor operation. Further, the assembly of the piezoelectric vibrator component can be effected more easily and more securely than in the prior art, so that the stability and reliability of the motor operation can markedly be enhanced.

One embodiment of the first piezoelectric vibrator for ultrasonic motors according to the present invention has been described above. It should be noted that various modifications can be made thereto in the present invention and that, for example, a piezoelectric vibrator of a single plate 10a may be employed as the piezoelectric vibrator component and a mounting member 12a having a pin hole as bonding means 14a at its side face may be used as the mounting member, as shown in Fig. 4.

In this embodiment, a piezoelectric vibrator of a single plate 10a is employed as the piezoelectric vibrator component and a mounting member 12a having a pin hole as bonding means 14a at its side face is used as the mounting member, and the piezoelectric vibrator 1a for ultrasonic motors is fixed to a fixture by means of a pin.

Although the mounting member 12a has the shape of substantially a rectangular parallelopiped in this embodiment, the shape of the mounting member 12a for use in the present invention is not limited thereto and various shapes can be employed as long as the objects of the present invention can be attained. Further, although the bonding means is a through pin hole opening at two mutually opposite side faces of the mounting member 12a in this example, the bonding means to be provided at the two mutually opposite side faces of the mounting member 12a in present invention is not limited thereto and any of the conventional bonding means such as a tapped hole (internal thread), a screw (external thread) and a cylindrical protrusion part can be employed. It is preferred that the above bonding means be formed around the center of each side face of the mounting member 12a. When the bonding means is formed around the center of each side face of the mounting member 12a, the lowering of the driving efficiency of the piezoelectric vibrator is minimized.

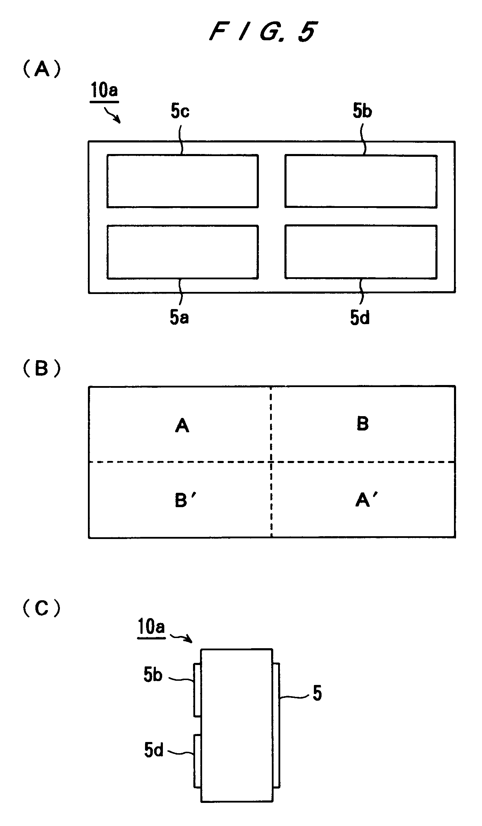

The piezoelectric vibrator of a single plate 10a used as the piezoelectric vibrator is formed from a ceramic composed mainly of a material having piezoelectric effect and is divided into four driving elements consisting of elements A and B arranged in the upper part and elements A' and B' arranged in the lower part as shown in Fig. 5 (B).

On one side face of the piezoelectric vibrator component of a single plate 10a, referring to Fig. 5 (A) and (C), the outside electrodes 5c, 5d, 5b and 5a are formed on the elements A, A', B and B', respectively. On the opposite side face of the single-plate piezoelectric vibrator, the outside electrode 5 is formed on substantially all the surface of the opposite side face of the single-plate piezoelectric vibrator. The outside electrodes 5a, 5b, 5c and 5d are insulated from each other.

When a voltage is impressed onto the outside electrodes 5, 5a, 5b, 5c and 5d of the single-plate piezoelectric vibrator 10a, an electric field applies in the direction of the thickness of the single-plate piezoelectric vibrator 10a. Upon application of an electric field, the elements A, A', B and B' conduct respective stretchings and shrinkages to thereby excite longitudinal vibration/bending vibration.

Specifically, the above single-plate piezoelectric vibrator 10a is driven by, for example, the following method.

A driving voltage is applied at a frequency of $\sin \omega t$ ($\omega$ is an angular frequency) to the elements A and A' and is applied at a frequency of $\cos \omega t$ ($\omega$ is an angular frequency) to the elements B and B' of the piezoelectric vibrator 10a. Thus, the single-plate piezoelectric vibrator 10a conducts elliptic motion at its ends as viewed in the driving direction to thereby generate a driving force in a certain direction. In Fig. 4, the driving force is generated in the arrowed or opposite direction. This driving force is transmitted to the part of contact between the sliding face of the single-plate piezoelectric vibrator 10a and the moving element or the like or the part of contact between the wear resisting members 13a, 13b and the moving element or the like, so that the single-plate piezoelectric vibrator 10a is driven as an ultrasonic motor by the frictional force produced at the contact part.

In this embodiment, the piezoelectric vibrator component is bonded through the elastic member to the mounting member having bonding means, so that the same functions and effects as in the above first embodiment are exerted.

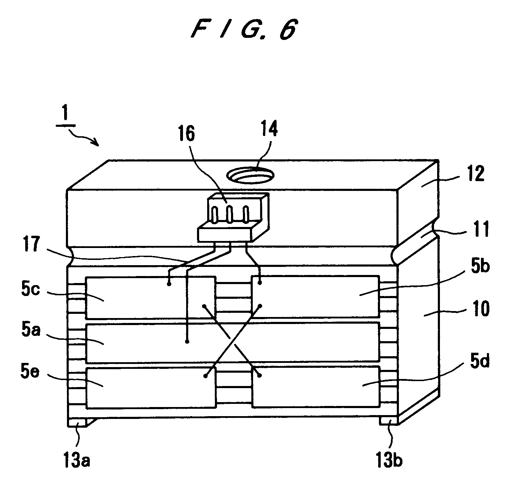

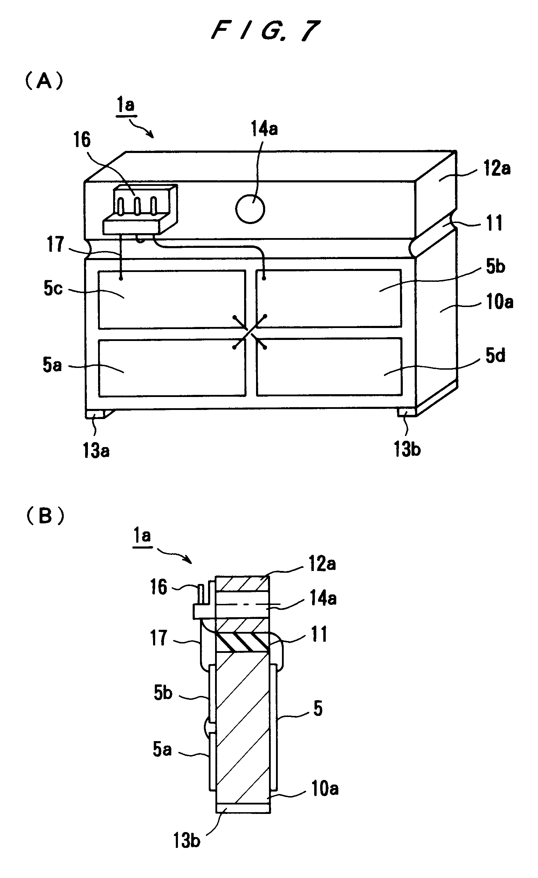

The piezoelectric vibrator for ultrasonic motors according to the present invention can further be modified. For example, the mounting members 12 and 12a may be provided with electric input terminals as shown in Figs. 6 and 7, respectively.

In the embodiment of Fig. 6, an electric input terminal 16 is provided around the center of a side face of the mounting member 12 of the piezoelectric vibrator 1 for ultrasonic motors shown in the above first embodiment. The above terminal is electrically connected to the outside electrodes 5a, 5b and 5c by means of a conductive material such as an electric wire. The outside electrode 5c is electrically connected with the outside electrode 5d and also the outside electrode 5a is electrically connected with the outside electrode 5b by means of a conductive material such as an electric wire.

In this embodiment, the piezoelectric vibrator component is bonded through the elastic member to the mounting member having bonding means, so that the same functions and effects as in the above embodiment 1 are exerted. Further, in this embodiment, the electric input terminal is provided, so that connection with a power source can easily be carried out.

In the embodiment of Fig. 7, an electric input terminal 16 is provided on a side face of the mounting member 12a of the piezoelectric vibrator 1a for ultrasonic motors shown in the above second embodiment. The above terminal is electrically connected to the outside electrodes 5, 5b and 5c by means of a conductive material such as an electric wire. The outside electrode 5c is electrically connected with the outside electrode 5d and also the outside electrode 5b is electrically connected with the outside electrode 5e by means of a conductive material such as an electric wire.

In this embodiment, the piezoelectric vibrator component is bonded through the elastic member to the mounting member having bonding means, so that the same functions and effects as in the above embodiment 1 are exerted. Further, in this embodiment, the electric input terminal is provided, so that connection with a power source can easily be carried out.

The present invention will further be described below in greater detail with reference to an experimental embodiment of a linear motor including the first piezoelectric vibrator for ultrasonic motors according to the present invention.

The piezoelectric vibrator for ultrasonic motors as described in the above first embodiment was assembled as shown in Fig. 3, thereby constructing a linear motor.

The piezoelectric vibrator component was a laminated piezoelectric vibrator having 13 inside electrode layers in each of the elements A, A', B and B' and 14 inside electrode layers in the element C in the lamination direction. This laminated piezoelectric vibrator comprised a laminate of 40 ceramic sheets of 115 $\mu$m in thickness each, and the size of the laminated piezoelectric vibrator was 21.0 mm in length, 4.8 mm in width and 5.4 mm in height. The top and bottom of the piezoelectric vibrator were provided with respective insulating layers. Silicone rubber was used as a material for forming the elastic member.

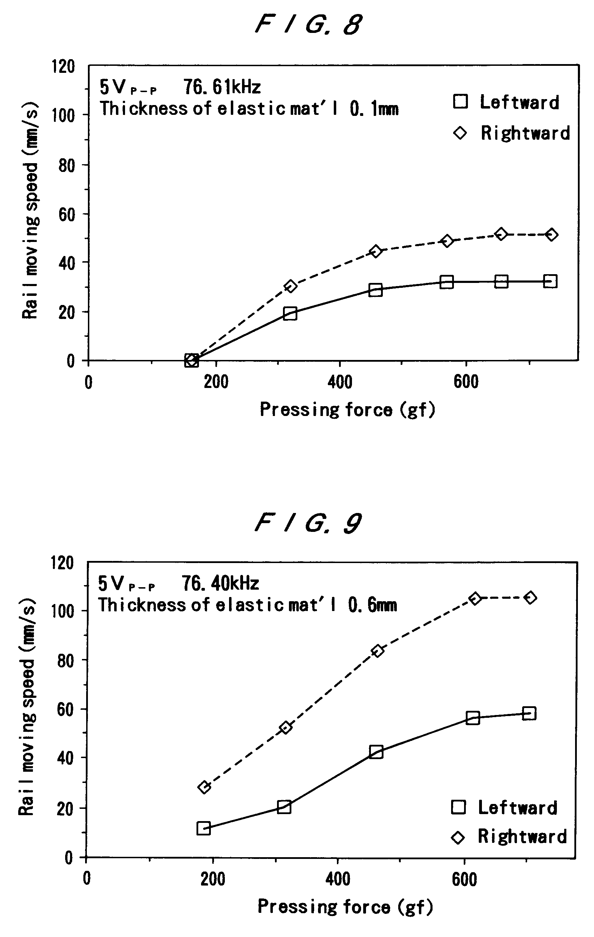

The average moving speed of a rail was measured with the use of the linear motor of the above structure under the conditions such that the thickness of the elastic member, the driving voltage and the driving frequency were 0.1 mm, 5 Vp-p and 76.61 kHz, respectively, while the pressing force was changed within the range of about 150 to 750 gf. The results are shown in Fig. 8.

The pressing force was measured by pressurizing the piezoelectric vibrator for ultrasonic motors against the rail on a force gauge. The moving distance was 110 mm and the rail weight was 38.7 g.

Moreover, the average moving speed of the rail was measured in the same manner as described above under the conditions such that the thickness of the elastic member, the driving voltage and the driving frequency were 0.6 mm, 5 Vp-p and 76.40 kHz, respectively, while the pressing force was changed within the range of about 190 to 700 gf. The results are shown in Fig. 9.

With respect to the piezoelectric vibrator for ultrasonic motors whose elastic member had a thickness of 0.1 mm, the moving speed of the rail was the greatest (50 mm/s in left direction and 30 mm/s in right direction) when the pressing force was in the range of about 650 to 730 gf. On the other hand, with respect to the piezoelectric vibrator for ultrasonic motors whose elastic member had a thickness of 0.6 mm, the moving speed of the rail was the greatest (106 mm/s in left direction and 55 mm/s in right direction) when the pressing force was in the range of about 610 to 700 gf.

The operation of a piezoelectric vibrator for ultrasonic motors in which the mounting member was directly bonded to the piezoelectric vibrator component was confirmed at a driving frequency of 75 to 79 kHz under a pressure changed between 300 and 600 gf. However, no linear operation could be confirmed.

The second piezoelectric vibrator for ultrasonic motors according to the present invention will now be described.

Referring to Fig. 10, for example, the second piezoelectric vibrator for ultrasonic motors 1b according to the present invention comprises a piezoelectric vibrator component 10b and a fixture 31, and the piezoelectric vibrator component 10b and the fixture 31 are bonded together through an elastic member 11 to thereby form an integral body. For example, adhesives can be employed to bond the piezoelectric vibrator component 10b to the elastic member 11 and bond the elastic member 11 to the fixture 31. Alternatively, the above bondings can be effected by providing the elastic member 11 with bonding capacity.

The bonding of the piezoelectric vibrator component to the fixture through the elastic member leads to elastic separation of the natural vibration of the piezoelectric vibrator component from the fixture by means of the elastic member. Therefore, the resonance characteristics of the piezoelectric vibrator component is not deteriorated and the stability and reliability of motor operation are markedly enhanced.

In the present invention, the piezoelectric vibrator component 10b may be either a laminated piezoelectric vibrator or a piezoelectric vibrator of a single plate.

The above piezoelectric vibrator 1b for ultrasonic motors according to the present invention is assembled in the ultrasonic motor as shown in Fig. 10. The moving element 33 is disposed so as to contact the wear resisting members 13a, 13b provided on the sliding face of the piezoelectric vibrator component 10b, supported by rollers 35 and urged by pressurization springs 37 against the piezoelectric vibrator component 10b.

In the second piezoelectric vibrator for ultrasonic motors according to the present invention, the piezoelectric vibrator component is bonded through the elastic member to the fixture, so that the resonance characteristics of the piezoelectric vibrator component is not deteriorated to thereby enable highly efficient motor operation. Further, the assembly of the piezoelectric vibrator component can be effected more easily and more securely than in the prior art, so that the stability and reliability of the motor operation can markedly be enhanced.

One embodiment of the second piezoelectric vibrator for ultrasonic motors according to the present invention has been described above. It should be noted, however, that the present invention is not limited to the above embodiment and various modifications can be made within the scope of the technical concept of the present invention.

The third piezoelectric vibrator for ultrasonic motors of the present invention and the process for producing the same will be described in detail below.

Referring to Fig. 11, the third piezoelectric vibrator 1c for ultrasonic motors according to the present invention is a cofiring laminated piezoelectric vibrator for ultrasonic motors which comprises a piezoelectric vibrator component 10 having opposite side faces provided at node parts thereof with respective bar-shaped bonding members 7a, 7b protrudent from the side faces, said bonding members enabling bonding with fixtures.

The piezoelectric vibrator component 10 is a laminated piezoelectric vibrator utilizing a longitudinal vibration/bending vibration as mentioned above. When a driving voltage is applied thereto, elliptic motions are excited at ends of the face (sliding face) of the piezoelectric vibrator component 10 opposite to the moving element, so that a driving force is produced in a fixed direction. In Fig. 11, the driving force is produced in the arrowed or opposite direction.

Linear wear resisting members 13a, 13b arranged substantially perpendicularly to the driving direction are provided at front and rear ends in the driving direction of the sliding face of the piezoelectric vibrator component 10. Although linear wear resisting members 13a, 13b are provided at ends of the sliding face of the piezoelectric vibrator component 10 in this embodiment, either planar wear resisting members may be provided in the vicinity of front and rear ends in the driving direction of the sliding face or a planar wear resisting member may be provided throughout the sliding face in the present invention.

A pair of side faces opposite to each other of the piezoelectric vibrator component 10 are provided at node parts thereof with respective bar-shaped bonding members 7a, 7b enabling bonding with fixtures which are formed so as to protrude from the side faces. The term "node part" used herein means the site at which the amplitude is nil when a driving voltage has been applied to the piezoelectric vibrator to thereby excite a longitudinal vibration/bending natural vibration.

Recessed parts 7a, 7b are formed at the node parts of the opposite side faces of the piezoelectric vibrator component 10, respectively. One end of each bonding member 7a, 7b is fitted in the corresponding recessed part 9a, 9b and the other end protrudes from the side face. In Fig. 11 (B), the screw threads of the bonding members 7a, 7b are not shown.

Although the bonding members 7a, 7b are provided with respective screw threads in this embodiment, the bonding members 7a, 7b for use in the present invention may be cylindrical members provided with no screw threads. Further, the recessed parts 9a, 9b may be a through hole and the bonding members may be in the form of a single bar.

The above piezoelectric vibrator 1c for ultrasonic motors according to the present invention is bonded to, for example, a fixture as shown in Fig. 12.

Referring to Fig. 12, a ⊐-shaped member 41 having at ends thereof notches 43a, 43b (not shown) for inserting the bonding members 7a, 7b, respectively, and having a screw (external thread) 42 at the center of the top face thereof is employed as the fixture 40. The bonding members 7a, 7b of the piezoelectric vibrator 1c for ultrasonic motors are inserted in the corresponding notches 43a, 43b and fastened by means of the corresponding nuts 45a, 45b.

The piezoelectric vibrator for ultrasonic motors according to the present invention has bonding members enabling bonding with a fixture to thereby fix the piezoelectric vibrator component, so that it is easy to stably fix the piezoelectric vibrator to the ultrasonic motor. Moreover, each bonding member is disposed at the node part of the vibration of the piezoelectric vibrator, so that the natural vibration of the piezoelectric vibrator is not inhibited.

The third piezoelectric vibrator for ultrasonic motors according to the present invention has been described. It should be noted, however, that the present invention is not limited thereto and various modifications can be made. Various forms of laminated piezoelectric vibrators can be employed as the piezoelectric vibrator component.

The above third piezoelectric vibrator for ultrasonic motors according to the present invention can be produced by, for example, the following process.

The piezoelectric vibrator component for use in the above piezoelectric vibrator for ultrasonic motors according to the present invention has the structure similar to that of the laminated piezoelectric vibrator shown in Fig. 2 and can be produced by substantially the same process as described above.

Specifically, first, a green sheet is obtained in the same manner as in the production of the piezoelectric vibrator components for use in the above first and second piezoelectric vibrators for ultrasonic motors. Although the thickness of this green sheet is not particularly limited, it is preferred to range from 0.02 to 2 mm, especially, from 0.05 to 0.5 mm.

A preferred green sheet manufacturing method comprises conducting extrusion with the use of water as the solvent to attain the sheeting. In this method, not only is it easy to reduce the amount of added binder and/or plasticizer but also the mutual adherence of green sheets is reduced at the time of the firing. Thus, when green sheets are laminated and fired, the adhesion of neighboring upper and lower sheets 3 can be prevented at the insulating part 4a, 4b, so that it becomes easy to securely form a gap (insulating part) at the above part. Nevertheless, green sheets adapted to securely form the insulating part 4a, 4b can be obtained by the extrusion technique in which an organic solvent is issued or the doctor blade technique in which an organic solvent or water is used, if the type and amount of added binder and plasticizer are appropriately selected.

A filmy inside electrode 2a, 2b can be formed by, for example, coating a surface of the green sheet with a metal paste. Examples of metals suitable for formation of the inside electrode 2a, 2b are as mentioned above.

It is desired that a metal paste which can be baked at the ceramic firing temperature be selected as the metal paste for forming the inside electrode 2a, 2b because the green sheet is fired after the lamination. For example, powdery zirconia, powdery glass and powder of the above piezoelectric material may be mixed with the metal paste in order to improve the adhesive strength between the green sheet and the inside electrode 2a, 2b after the firing.

In the application of the metal paste to the surface of the green sheet, part noncoated with the metal paste is provided at a peripheral edge of a green sheet to thereby form part intended for use as the insulating part 4a positioned at an end of the inside electrode 2b. Further, part noncoated with the metal paste is provided at the longitudinal center of the green sheet to thereby form part intended for use as the insulating part 4b positioned between the inside electrodes 2b, 2b. Still further, part noncoated with the metal paste is provided at a peripheral edge of another green sheet to thereby form part intended for use as the insulating part 4a positioned at an end of the inside electrode 2a. The shape and position of the insulating part 4a are not particularly limited, and it may be formed at one corner of the green sheet.

Although the thickness of the above inside electrode 2a, 2b is not particularly limited, it is preferred to range from 0.5 to 20 μm, especially, from 1 to 10 μm after the firing. The application of the metal paste can be conducted by, for example, the screen printing or the roller printing technique.

A plurality of the above green sheets provided with respective inside electrodes 2b are laminated together in a manner such that the insulating parts 4a position alternately right and left when facing in the lamination direction to thereby produce each of laminate A-B destined for elements A and B and laminate A'-B' destined for elements A' and B'. On the other hand, a plurality of the above green sheets provided with respective inside electrodes 2a are laminated together in a manner such that the insulating parts 4a position alternately right and left when facing in the lamination direction to thereby produce laminate C destined for element C. The resultant laminate A-B, laminate C and laminate A'-B' are piled one upon another in this order to thereby obtain a laminate of green sheets.

Thereafter, recessed parts are formed at sites destined to become node parts of a pair of mutually opposite side faces of the resultant green sheet laminate. That is, recessed parts are provided at node part sites of a pair of mutually opposite side faces of the piezoelectric vibrator component produced from the green sheet laminate.

This green sheet laminate provided with the recessed parts is subjected to degreasing and firing at a given temperature to thereby obtain a ceramic sheet laminate, which is then subjected to baking of the inside electrodes 2a, 2b to thereby effect bonding between the ceramic sheets and the respective inside electrodes 2a, 2b. The above laminate may be cut into a given size prior to the degreasing. Alternatively, the cutting may be conducted after the firing. In the above laminate firing, neighboring upper and lower ceramic sheets do not adhere to each other, so that the insulating parts 4a, 4b can be securely formed.

The recessed parts of the thus obtained ceramic sheet laminate (piezoelectric vibrator) are machined to give cuts according to necessity, and one end of each bar-shaped bonding member enabling bonding with a fixture is fitted in the corresponding recessed part. In the fitting of the bonding members in the recessed parts, an adhesive, etc. may be used.

Each of the outside electrodes 5, 5a, 5b, 5c, 5d and 5e can easily be formed by applying an electrode material onto a side face in the longitudinal direction of the piezoelectric vibrator component 10 and baking the same.

Thus, a piezoelectric vibrator having side faces opposite to each other provided with respective bar-shaped bonding members enabling bonding with a fixture in a manner such that they are protrudent from the side faces is obtained.

The first ultrasonic motor of the present invention will be illustrated below.

Referring to Figs. 13 and 14, in the ultrasonic motor 50 of this embodiment, the piezoelectric vibrator component 10 is disposed around the center of one face of a substantially rectangular bonding material 51 and magnets 52a, 52b are disposed in the vicinities of sides opposite to each other of the same face, respectively.

The bonding material 51 is composed of, for example, a synthetic resin or a metal. Although the bonding material 51 is substantially rectangular in this embodiment, the shape of the bonding material 51 for use in the present invention is not particularly limited as long as the shape is suitable for enabling bonding of the piezoelectric vibrator component 10 and the magnets 52a, 52b. For example, the bonding material 51 may be bar-shaped. Further, in this embodiment, a channel is formed at substantially the center of one face of the bonding material 51 at which the piezoelectric vibrator component 10 is arranged. However, this channel is not necessarily required in the present invention.

The piezoelectric vibrator component 10 may either be bonded (fixed) to the bonding material 51 with the use of, for example, an adhesive or may be in a nonbonded (nonfixed) state. In this case, it is satisfactory, for example, to form a recessed part conforming with the configuration of the top of the piezoelectric vibrator component 10 on the bottom face of the plate-shaped bonding material 51 and to loosely fit the top of the piezoelectric vibrator component 10 in the above recessed part.

The piezoelectric vibrator component 10 is a piezoelectric vibrator utilizing a longitudinal vibration/bending vibration as mentioned above. When a driving voltage is applied thereto, elliptic motions are excited at both ends of the face (sliding face) of the piezoelectric vibrator component 10 opposite to the driving surface 55, so that a driving force is produced in a fixed direction. In Fig. 13 (B), the ultrasonic motor 50 moves in the arrowed or opposite direction.

Linear wear resisting members 13a, 13b arranged substantially perpendicularly to the driving direction are provided at front and rear ends in the driving direction of the sliding face of the piezoelectric vibrator component 10, namely, at sites where the piezoelectric vibrator component 10 is endowed with a driving force.

The magnets 52a, 52b are disposed substantially symmetrically with respect to the piezoelectric vibrator component 10 on the same face of the bonding material 51 as provided with the piezoelectric vibrator component 10. The magnets 52a, 52b are disposed apart from the driving surface 55, that is, the magnets 52a, 52b are disposed so that only the above wear resisting members 13a, 13b come into contact with the driving surface 55.

The magnets 52a, 52b are generally bonded to one face of the bonding material 51 with an adhesive. However, when the bonding material 51 is a magnetic material, the magnets 52a, 52b may be bonded with (attract) the bonding material 51 by magnetic force.

In the ultrasonic motor of the present invention, magnets are used as means for pressurizing the piezoelectric vibrator component against the driving surface composed of a magnetic material, so that the pressurization mechanism can be simplified.

Further, wear resisting members are provided at specified positions of the sliding face of the piezoelectric vibrator component to thereby restrict the part of contact with the driving surface, so that not only any unnecessary frictional resistance but also the effect of elliptic motion induced in an opposite direction so as to obstruct the driving can be prevented. Thus, the driving efficiency can be enhanced. Still further, the pressure application required for the driving can be attained with the use of small magnets, so that the miniaturization of the ultrasonic motor can be achieved.

The driving surface used for driving the ultrasonic motor of the present invention is not limited as long as it is smooth and composed of a magnetic material. The driving surface enables driving not only in the horizontal direction but also in the vertical direction. Moreover, a combination of at least two piezoelectric vibrator components enables free travel on the X-Y plane with no restriction imposed on the range of move. Further, a rotary motor of simple mechanism based on direct pressurization onto a bearing can be structured.

The ultrasonic motor of the present invention is as described above. However, the present invention is not limited thereto and various modifications can be effected. For example, a second ultrasonic motor may be provided in which, referring to Fig. 15, the piezoelectric vibrator component 10 is bonded through the elastic member 11 to the bonding material 51.

In this embodiment, substantially all the face of the piezoelectric vibrator component 10 opposite to the sliding face is bonded with one face of the bonding material 51 through the elastic member 11.

The thickness of the elastic member 11 generally ranges from about 0.1 to 2.5 mm and preferably from about 0.1 to 1 mm.

The elastic member 11 can be bonded with the piezoelectric vibrator component 10 and also with the bonding material 51 with the use of an adhesive, etc.

In the above ultrasonic motor of the present invention, magnets are used as means for pressurizing the piezoelectric vibrator component against the driving surface composed of a magnetic material and, further, wear resisting members are provided on the sliding face of the piezoelectric vibrator component to thereby restrict the part of contact with the driving surface, so that the same functions and effects as those of the above first embodiment are exerted.

Furthermore, the piezoelectric vibrator component is bonded with the bonding material through the elastic member in the ultrasonic motor of the present invention, so that the natural vibration of the piezoelectric vibrator component is elastically separated from the bonding material by means of the elastic member. Thus, the resonance characteristics of the piezoelectric vibrator component are not deteriorated to thereby enable operating the ultrasonic motor in high efficiency.

The present invention will further be described below in greater detail with reference to an experimental example in which the ultrasonic motor according to the present invention is used.

The test was conducted with the use of the ultrasonic motor as described in the above first embodiment. The piezoelectric vibrator component was a laminated piezoelectric vibrator having 13 inside electrode layers in each of the elements A, A', B and B' and 14 inside electrode layers in the element C in the lamination direction. This laminated piezoelectric vibrator comprised a laminate of 40 ceramic sheets of 115 $\mu$m in thickness each, and the size of the laminated piezoelectric vibrator was 21.0 mm in length, 4.8 mm in width and 5.4 mm in height. The top and bottom of the piezoelectric vibrator were provided with respective insulating layers. The bonding material was composed of a resin and had a size of 25 mm x 28 mm. The pressure applied by the magnets was 285 gf and the weight of the ultrasonic motor was 16 g.

The ultrasonic motor of the above structure was traveled at a driving voltage of 4 Vp-p on a vertically arranged smooth magnetic material surface with the result that the obtained moving speeds thereof were 55 mm/s in the horizontal direction and 26 mm/s in the vertical direction.

## EFFECT OF THE INVENTION

The first piezoelectric vibrator for ultrasonic motors according to the present invention is substantially free from deteriorating the resonance characteristics of the piezoelectric vibrator component to thereby enable operating the ultrasonic motor in high efficiency. Further, the assembly of the piezoelectric vibrator component can be effected more easily and more securely than in the prior art, so that the stability and reliability of the motor operation can markedly be enhanced.

The second piezoelectric vibrator for ultrasonic motors according to the present invention is substantially free from deteriorating the resonance characteristics of the piezoelectric vibrator component to thereby enable operating the ultrasonic motor in high efficiency. Further, the assembly of the piezoelectric vibrator component can be effected more easily and more securely than in the prior art, so that the stability and reliability of the motor operation can markedly be enhanced.

The method of mounting the piezoelectric vibrator component according to the present invention is substantially free from deteriorating the resonance characteristics of the piezoelectric vibrator component, so that not only can the ultrasonic motor be operated in high efficiency but also the stability and reliability of the motor operation can markedly be enhanced.

The third piezoelectric vibrator for ultrasonic motors according to the present invention has a bonding member enabling bonding with a fixture, so that the assembly thereof into the ultrasonic motor is easy. Further, the bonding member is disposed at the node part of vibration, so that the natural vibration of the piezoelectric vibrator component is not inhibited.

The process for producing a piezoelectric vibrator for ultrasonic motors according to the present invention does not need any special technology and can be employed in production of a piezoelectric vibrator for ultrasonic motors having a bonding member enabling bonding with a fixture.

The first and second ultrasonic motors of the present invention not only realize simplification of the pressurization mechanism and miniaturization of the motor but also ensure high driving efficiency. Especially, the second ultrasonic motor is substantially free from deteriorating the resonance characteristics of the piezoelectric vibrator component to thereby enable further enhancing the driving efficiency.

**Claims**

1. A piezoelectric vibrator for ultrasonic motors capable of causing a piezoelectric vibrator component to generate a longitudinal vibration/bending vibration to thereby drive a moving element, said piezoelectric vibrator comprises:
   a piezoelectric vibrator component and a mounting member having means for bonding with a fixture, said piezoelectric vibrator component and mounting member being bonded together through an elastic member.

2. A piezoelectric vibrator for ultrasonic motors as claimed in claim 1, wherein a wear resisting member is disposed on a face of the piezoelectric vibrator component opposite to the moving element.

3. A piezoelectric vibrator for ultrasonic motors as claimed in claim 1 or 2, wherein the mounting member is provided with an electric input terminal.

4. A piezoelectric vibrator for ultrasonic motors capable of causing a piezoelectric vibrator component to generate a longitudinal vibration/bending vibration to thereby drive a moving element, said piezoelectric vibrator comprises:
   a piezoelectric vibrator component and a fixture, said piezoelecric vibrator component and a fixture being bonded through an elastic member.

5. A method of mounting a piezoelectric vibrator, which comprises bonding a piezoelectric vibrator component through an elastic member to a fixture, said piezoelectric vibrator component being capable of generating a longitudinal vibration/bending vibration to thereby drive a moving element.

6. A piezoelectric vibrator for ultrasonic motors, said vibrator comprising a cofiring laminated piezoelectric vibrator for ultrasonic motors having respective protrudent bar-shaped bonding members in opposite side surface thereof for enabling bonding with fixtures, each of said bonding members being partly fitted in a recessed part formed at a node part of the corresponding side face of the laminated piezoelectric vibrator.

7. A piezoelectric vibrator for ultrasonic motors as claimed in claim 6, wherein said laminated piezoelectric vibrator is a vibrator utilizing a longitudinal vibration mode/bending vibration mode.

8. A process for producing a piezoelectric vibrator for ultrasonic motors, said process comprises:
   integrally laminating green sheets each composed mainly of a ceramic material having piezoelectric effect to thereby obtain a green sheet laminate,
   forming respective recessed parts at opposite side faces of the green sheet laminate on sites which become node parts at the time of formation of a piezoelectric vibrator and thereafter firing the green sheet laminate to thereby obtain a ceramic laminate, and
   fitting one end of each bar-shaped bonding member for enabling bonding with a fixture in the corresponding recessed part of the ceramic laminate, thereby obtaining a laminated piezoelectric vibrator having the bonding members protruding from the respective side faces.

9. An ultrasonic motor of the standing-wave type, said ultrasonic motor comprising a piezoelectric vibrator capable of exciting two modes of natural vibrations different from each other when a driving voltage is applied thereto, said ultrasonic motor utilizing as a driving force an elliptic motion synthesized from the two modes of natural vibrations and a frictional force occurring between the piezoelectric vibrator and a driving surface, wherein said piezoelectric vibrator is provided with a wear resisting member at its face opposite to the driving surface in the vicinity of an end thereof in the driving direction and is bonded with a magnet for pressurizing the piezoelectric vibrator against the driving surface composed of a magnetic material by means of a bonding material, said magnet being disposed apart from the driving surface.

10. An ultrasonic motor as claimed in claim 9, wherein said bonding material is composed of a magnetic material, so that the magnet is bonded with the bonding material by magnetic force.

11. An ultrasonic motor as claimed in claim 9 or 10, wherein said piezoelectric vibrator is a laminated piezoelectric vibrator utilizing a longitudinal vibration mode/bending vibration mode.

12. An ultrasonic motor as claimed in any of claims 9 to 11, wherein the piezoelectric vibrator and the bonding material are bonded with each other in nonadhering (nonfixed) relationship.

13. An ultrasonic motor as claimed in any of claims 9 to 12, wherein the piezoelectric vibrator and the bonding material are bonded with each other through an elastic member.

# F I G. 1

# F I G. 2

(A)

(B)

| A | B |
|---|---|
| C | |
| B' | A' |

(C)

# F I G. 3

# F I G. 4

# F I G. 5

（A）

10a

5c     5b

5a     5d

（B）

| A | B |
|---|---|
| B′ | A′ |

（C）

10a

5b

5d

5

# F I G. 6

## F I G. 7

(A)

(B)

## F I G. 8

5 V$_{P-P}$    76. 61kHz
Thickness of elastic mat' l 0. 1mm

☐ Leftward
◇ Rightward

Rail moving speed (mm/s)

Pressing force (gf)

## F I G. 9

5 V$_{P-P}$    76. 40kHz
Thickness of elastic mat' l 0. 6mm

☐ Leftward
◇ Rightward

Rail moving speed (mm/s)

Pressing force (gf)

21

# F I G. 1 0

(A)

(B)

F I G. 1 1

(A)

1c

5c

5a

5e

5b

10

5d

13a          7a          13b

(B)

1c

5c

5a

7a          7b

9a          9b

5e

10

5

13a

## F I G. 1 2

（A）

（B）

# F I G. 1 3

## (A)

## (B)

*F I G. 1 4*

## F I G. 1 5

## F I G. 1 6

(A)　　　　　　　　　　　　(B)

# EP 0 725 476 A1

**INTERNATIONAL SEARCH REPORT**

| International application No. |
|---|
| PCT/JP95/01609 |

**A. CLASSIFICATION OF SUBJECT MATTER**

Int. Cl$^6$ H02N2/00

According to International Patent Classification (IPC) or to both national classification and IPC

**B. FIELDS SEARCHED**

Minimum documentation searched (classification system followed by classification symbols)

Int. Cl$^6$ H02N2/00

Documentation searched other than minimum documentation to the extent that such documents are included in the fields searched

| Jitsuyo Shinan Koho | 1926 – 1995 |
| Kokai Jitsuyo Shinan Koho | 1971 – 1995 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP, 63-124785, A (Taga Denki K.K.),<br>May 28, 1988 (28. 05. 88),<br>Lines 7 to 8, column 1 (Family: none) | 1, 2, 3, 4,<br>5, 6, 7, 8 |
| Y | JP, 6-169582, A (Nisuka K.K.),<br>June 14, 1994 (14. 06. 94)(Family: none) | 1, 2, 3, 4,<br>5, 6, 7, 8, 11 |
| Y | JP, 3-48390, U (Tamura Electric Works, Ltd.),<br>May 9, 1991 (09. 05. 91)(Family: none) | 2 |
| Y | JP, 4-88890, A (Fujitsu Ltd.),<br>March 23, 1992 (23. 03. 92)(Family: none) | 10 |
| EY | JP, 6-334236, A (Fujitsu Ltd.),<br>December 2, 1994 (02. 12. 94)(Family: none) | 8 |

☐ Further documents are listed in the continuation of Box C.     ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| October 30, 1995 (30. 10. 95) | November 21, 1995 (21. 11. 95) |

| Name and mailing address of the ISA/ | Authorized officer |
|---|---|
| Japanese Patent Office | |
| Facsimile No. | Telephone No. |

Form PCT/ISA/210 (second sheet) (July 1992)

28